# EUROPÄISCHE PATENTANMELDUNG

(11) **EP 4 296 757 A2**
(43) Veröffentlichungstag der Anmeldung: **27.12.2023**
(21) Anmeldenummer: 23176887.0
(22) Anmeldetag: 02.06.2023
(51) Int. Cl.: G02B 27/01, A42B 3/04, F16M 11/10, F16M 11/18, F16M 13/04, G02C 3/00, G02C 3/02

(54) **HMD-VORRICHTUNG UND GEGENGEWICHTSELEMENT ZUR ANORDNUNG AN EINER TRÄGERVORRICHTUNG EINER SOLCHEN HMD-VORRICHTUNG**

(30) Priorität: 03.06.2022 DE 202022103168 U
(71) Anmelder: BHS Technologies GmbH, 6020 Innsbruck (AT)
(72) Erfinder: CAPELLI, Mark, 6020 Innsbruck (AT); SCHMID-SANTEK, Michael, 6091 Götzens (AT)
(74) Vertreter: Prüfer & Partner mbB Patentanwälte · Rechtsanwälte

(57) **Zusammenfassung**

Die vorliegende Erfindung betrifft eine HMD-Vorrichtung (1), aufweisend:
zumindest eine Anzeigevorrichtung (10) zur Anzeige eines aufgenommenen Bildes,
eine Trägervorrichtung (20), an der die zumindest eine Anzeigevorrichtung (10) befestigt ist und zumindest einen Befestigungsabschnitt zur Befestigung an einem Kopf eines Nutzers aufweist, und
zumindest ein Gegengewichtselement (21), über das eine Gegengewichtskraft zur Gewichtskraft der zumindest einen Anzeigevorrichtung aufbringbar ist, wobei
das zumindest eine Gegengewichtselement (21) derart an der Trägervorrichtung (20) angeordnet ist, dass das durch die Gewichtskraft des Gegengewichtselement (21) bedingte Gegengewichtsmoment dem durch die Gewichtskraft der Anzeigevorrichtung (10) bedingten Anzeigevorrichtungsmoment entgegengesetzt wirkt.

## Beschreibung

Die vorliegende Erfindung betrifft eine HMD-Vorrichtung sowie ein Gegengewichtselement zur Anordnung an einer Trägervorrichtung einer solchen HMD-Vorrichtung.

HMD-Vorrichtungen bzw. Head-Mounted-Display-Vorrichtungen werden vielfach eingesetzt, um einem Nutzer Bilder direkt im Sichtfeld anzeigen zu können, ohne dass dieser seinen Blick auf einen ortsfesten Monitor oder dergleichen richten muss. Gerade bei medizinischen Anwendungen ist die Genauigkeit der Bildwiedergabe, aber auch der Bildwahrnehmung durch den Nutzer, wie einen Operateur, zur präzisen Durchführung eines medizinischen Eingriffs maßgeblich. Hinzu kommen Anforderungen an den Tragekomfort, um den Nutzer bei insbesondere langen medizinischen Eingriffen nicht bzw. möglichst geringfügig durch das Tragen der HMD-Vorrichtung zu beeinträchtigen.

Zur Anzeige entsprechender Bilder umfassen HMD-Vorrichtungen üblicherweise eine Trägervorrichtung, die durch einen Nutzer am Kopf getragen wird und an der im Bereich der Augen des Nutzers eine Anzeigevorrichtung befestigt ist. Durch das Gewicht der Anzeigevorrichtung ist der Schwerpunkt der HMD-Vorrichtung von der Wirbelsäule eines Nutzers aus gesehen in Richtung der Augen verlagert. Dies bewirkt ein Moment, das beim Tragen der HMD-Vorrichtung von den Augen aus in Richtung des Kinns eines Nutzers und somit auf den Nacken wirkt. Dies kann den Tragekomfort bzw. die Ergonomie erheblich beeinflussen.

Zudem kann bei nicht richtiger Befestigung der Trägereinrichtung am Kopf das Moment ein Verkippen der HMD-Vorrichtung bewirken, wodurch die Anzeigevorrichtung nicht mehr in der vorbestimmten Position relativ zu den Augen gehalten werden und ggf. auch herunterfallen kann. Dies kann die Sicherheit bei einem medizinischen Eingriff gefährden. Wird hingegen zur Vermeidung eines Verkippens der HMD-Vorrichtung die Trägervorrichtung stärker am Kopf eines Nutzers festgezogen, so wirkt sich dies wiederum weiter nachteilig auf den Tragekomfort aus.

In Anbetracht der vorstehenden Ausführungen ist es somit Aufgabe der vorliegenden Erfindung, eine gegenüber dem Stand der Technik, insbesondere im Hinblick auf einen Tragekomfort und/oder sicheres Halten einer Trageposition, verbesserte HMD-Vorrichtung bereitzustellen.

Diese Aufgabe wird durch die Gegenstände der unabhängigen Ansprüche gelöst. Vorteilhafte Weiterbildungen sind Gegenstand der Unteransprüche.

Erfindungsgemäß weist eine HMD-Vorrichtung zumindest eine Anzeigevorrichtung zur Anzeige eines aufgenommenen Bildes, eine Trägervorrichtung, an der die zumindest eine Anzeigevorrichtung befestigt ist und zumindest einen Befestigungsabschnitt zur Befestigung an einem Kopf eines Nutzers aufweist, und zumindest ein Gegengewichtselement, über das eine Gegengewichtskraft zur Gewichtskraft der zumindest einen Anzeigevorrichtung aufbringbar ist, auf. Dabei ist das zumindest eine Gegengewichtselement derart an der Trägervorrichtung angeordnet, dass das durch die Gewichtskraft des Gegengewichtselements bedingte Gegengewichtsmoment dem durch die Gewichtskraft der Anzeigevorrichtung bedingten Anzeigevorrichtungsmoment entgegengesetzt wirkt.

Das Gegengewichtselement kann somit das auf einen Nutzer der HMD-Vorrichtung wirkende Anzeigevorrichtungsmoment, das durch die Gewichtskraft der zumindest einen Anzeigevorrichtung aufgebracht wird, reduzieren oder ausgleichen. Beispielsweise kann die Trägervorrichtung zumindest einen um den Kopfumfang eines Nutzers herumführbaren Trägerkranz oder Trägerriemen als Befestigungsabschnitt zum Tragen der HMD-Vorrichtung aufweisen. Gemäß dieser ringförmigen Ausgestaltung des Befestigungsabschnitts kann das Gegengewichtselement auf einer Ringseite des Befestigungsabschnitts angeordnet sein, der der Ringseite des Befestigungsabschnitts, an dem die zumindest eine Anzeigevorrichtung angeordnet ist, gegenüberliegend ist. Insbesondere kann der Abstand zwischen der zumindest einen Anzeigevorrichtung und dem Gegengewichtselement entlang des Umfangs des ringförmigen Befestigungsabschnitts 180° betragen, so dass der Schwerpunkt der HMD-Vorrichtung im Wesentlichen in der Mitte der Halswirbelsäule liegt.

Das Gewicht des zumindest einen Gewichtgewichtselements wird dabei bevorzugt so gewählt, dass die daraus resultierende Gewichtskraft in zumindest einer vorbestimmten Relativposition das durch die Gewichtskraft der zumindest einen Anzeigevorrichtung wirkende Anzeigevorrichtungsmoment in Bezug auf die Mitte der Halswirbelsäule aufhebt. Entsprechend kann das auf den Nacken eines Nutzers wirkende Moment aufgehoben oder zumindest reduziert werden.

Es können auch mehrere Gegengewichtselemente an der Trägervorrichtung anordenbar oder befestigbar sein. Hierüber kann dann das wirkende Gegengewichtsmoment flexibel eingestellt werden kann.

Ungeachtet der Anzahl der Gegengewichtselemente ist das zumindest eine Gegengewichtselement oder sind die mehreren Gegengewichtselemente in Bezug auf einen zu erreichenden vorbestimmten Schwerpunkt auf einer anderen Seite der Trägervorrichtung als die zumindest eine Anzeigevorrichtung angeordnet. Andernfalls würde das Gegengewichtsmoment dem Anzeigevorrichtungsmoment nicht entgegenwirken.

Sofern die Relativposition der zumindest einen Anzeigevorrichtung veränderbar ist, ist das zumindest eine Gegengewichtselement auf eine während der Nutzung üblicherweise überwiegend eingehaltene Relativposition der zumindest einen Anzeigevorrichtung angepasst. Zum Beispiel kann die HMD-Vorrichtung eine Anzeigevorrichtung aufweisen, die um eine zum Augenabstand parallele Achse in und aus dem Blickfeld eines Nutzers geschwenkt werden kann. Diese HMD-Vorrichtung kann für minimalinvasive Eingriffe genutzt werden, bei denen davon ausgegangen wird, dass die Anzeigevorrichtung überwiegend im Sichtfeld des Nutzers angeordnet ist. Entsprechend kann bzw. können die Position und/oder das Gewicht des Gegengewichtselements an das Anzeigevorrichtungsmoment im eingeschwenkten Zustand der Anzeigevorrichtung, also bei Positionierung der Anzeigevorrichtung im Sichtfeld, angepasst sein. Wird nun die Anzeigevorrichtung aus dem Sichtfeld hinausgeschwenkt, zum Beispiel um 90° nach oben, verlagert sich der Schwerpunkt bei ansonsten gleichbleibenden Bedingungen vom Gegengewicht weg, so dass sich auch das Verhältnis des Anzeigevorrichtungsmoments zum Gegengewichtsmoment verändert. Durch die Veränderung des Schwerpunkts in Richtung der zumindest einen Anzeigevorrichtung nimmt als die Wirkung des Gegengewichtsmoments entgegen des Anzeigevorrichtungsmoments ab. Da diese Schwerpunktverlagerung bewegt sich allerdings in einem überschaubaren Bereich und wird gemäß vorstehender Angaben als vergleichsweise kurzer bzw. seltener Zustand angenommen. Der Tragekomfort wird somit nur vorübergehend und in geringem Ausmaß beeinträchtigt. Bei Anwendungen, bei denen die Anzeigevorrichtung überwiegend aus dem Sichtfeld des Nutzers ausgeschwenkt angeordnet ist, kann entsprechend umgekehrt eine Anpassung des Gegengewichtselements an die dann überwiegend herrschenden Verhältnisse erfolgen.

In einer Ausgestaltung ist das Gegengewichtselement lösbar mit der Trägervorrichtung verbindbar.

Das Gegengewichtselement kann somit beispielsweise zum Austausch gegen ein anderes Gegengewichtselement und/oder zur anderweitigen Anpassung des wirkenden Gegengewichtsmoments und/oder zur Desinfektion oder Sterilisierung von der Trägervorrichtung entfernt und wieder angeordnet werden. Die lösbare Verbindung kann als Schraubverbindung und/oder andere form- und/oder kraftschlüssige Verbindung, wie beispielsweise über Schnapphaken, Schnappverschlüsse und dergleichen, ausgebildet sein.

In einer Ausgestaltung ist das Gegengewichtselement an verschiedenen Positionen der Trägervorrichtung und/oder in verschiedenen Position relativ zur Trägervorrichtung anordenbar.

Die Anordenbarkeit des zumindest einen Gegengewichtselements an verschiedenen Positionen der Trägervorrichtung bezieht sich dabei auf eine Befestigung des zumindest einen Gegengewichtselements an verschiedene Positionen entlang der Trägervorrichtung. Alternativ oder ergänzend kann das Gegengewichtselement aber auch ausgehend von einer Befestigungsposition an der Trägervorrichtung in verschiedenen Positionen relativ zur Trägervorrichtung anordenbar sein. Hierzu kann das zumindest eine Gegengewichtselement in Bezug auf eine Befestigungsposition über ein Gelenk verschwenkbar und/oder über eine Führung verschiebbar sein. Das Gegengewichtsmoment kann durch die Anordenbarkeit des Gegengewichtselements in verschiedenen Positionen relativ zur Trägervorrichtung feinjustiert werden.

In einer Ausgestaltung ist die HMD-Vorrichtung dazu konfiguriert, die Position des zumindest einen Gegengewichtselements an und/oder zur Trägervorrichtung in Abhängigkeit einer Bewegung und/oder eines Gewichts der zumindest einen Anzeigevorrichtung zu verändern.

Nochmals beispielhaft bezugnehmend auf die vorstehend beschriebene verschwenkbare Anzeigevorrichtung, kann somit das wirkende Gegengewichtsmoment auf eine veränderte Position der Anzeigevorrichtung relativ zur Trägervorrichtung angepasst werden. Wird beispielsweise bei einem Herausschwenken der Anzeigevorrichtung aus dem Sichtfeld eines Nutzers der Schwerpunkt tendenziell von der Kopfmitte weg verlagert, so kann das Gegengewichtselement gleichermaßen nach entgegengesetzt der Bewegung der Anzeigevorrichtung bewegt werden, um die Schwerpunktverlagerung zu kompensieren. Sind zwei Anzeigevorrichtungen, also für das jeweilige Auge getrennte Anzeigevorrichtungen, an der Trägervorrichtung befestigt, so kann eine Ausgleichsbewegung des Gegengewichtelements in Abhängigkeit der jeweiligen Bewegung der einen und/oder anderen Anzeigevorrichtung erfolgen. Zum Beispiel kann eine volle Ausgleichsbewegung bei entsprechender Bewegung beider Anzeigevorrichtungen erfolgen, während die Ausgleichsbewegung bei Bewegung nur einer Anzeigevorrichtung nur in entsprechend reduziertem Ausmaß ausgeführt wird.

Alternativ oder ergänzend kann eine zumindest teilweise Kompensation einer Schwerpunktverlagerung infolge einer Gewichtsänderung der Anzeigevorrichtung vorgesehen sein. Das Gewicht der Anzeigevorrichtung kann sich beispielsweise durch Anbringung von Zusatzkomponenten oder durch Austausch der Anzeigevorrichtung verändern, so dass auch dann eine Anpassung des Gegengewichtsmoments vorteilhaft sein kann.

Die Veränderung der Position des zumindest einen Gegengewichtselements an und/oder zur Trägervorrichtung in Abhängigkeit einer Bewegung und/oder eines Gewichts der zumindest einen Anzeigevorrichtung kann durch eine signaltechnische Ansteuerung eines Antriebsmechanismus für das zumindest eine Gegengewichtselement erfolgen. Beispielsweise kann ein die HMD-Vorrichtung einen Gewichtssensor ausweisen, der ein Gewicht oder eine Gewichtsänderung der zumindest einen Anzeigevorrichtung detektiert. Ebenso kann über einen Sensor eine Bewegung der zumindest einen Anzeigevorrichtung relativ zur Trägervorrichtung erfasst werden. Neben der direkten Messung entsprechender Größen können aber auch entsprechende Ansteuerungssignale der zumindest einen Anzeigevorrichtung, die mit entsprechende Bewegung gleichzusetzen sind, zur Veränderung der Position des zumindest einen Gegengewichtselements herangezogen werden.

Um eine Veränderung der Position des Gegengewichtselements nicht bei jeder kleinen und/oder kurzfristigen Positions- und/oder Gewichtsänderung der zumindest einen Anzeigevorrichtung vorzunehmen, kann zur Ansteuerung des Gegengewichtselements eine Zeitbedingung berücksichtigt werden. Demnach wird die Position des zumindest einen Gegengewichtselements beispielsweise erst dann verändert, wenn sich die Position und/oder das Gewicht der Anzeigevorrichtung über einen vorbestimmten Mindestzeitraum verändert hat. Alternativ oder ergänzend kann eine Veränderung der Position des zumindest einen Gegengewichtselements auch nur dann vorgesehen werden, wenn eine vorbestimmte Mindestveränderung der zumindest einen Anzeigevorrichtung eingetreten ist. Die vorbestimmte Mindestveränderung und/oder Zeitbedingung können bzw. kann an die Wirkung der entsprechenden Anzeigevorrichtungsmomentänderung angepasst werden. Zum Beispiel kann bei einem hohen Gewicht der zumindest einen Anzeigevorrichtung eine Positionsveränderung des zumindest einen Gegengewichtselements schon nach kürzerer Zeit und/oder bei geringerer vorbestimmter Mindestveränderung der Anzeigevorrichtungsposition vorgesehen sein. Bei einem geringeren Gewicht der zumindest einen Anzeigevorrichtung kann eine größere Veränderungstoleranz eingestellt sein.

Alternativ oder ergänzend zu einer signaltechnischen Ansteuerung und damit Veränderung der Position des zumindest einen Gegengewichtselements kann auch eine mechanische Ansteuerung vorgesehen sein. Beispielsweise können die zumindest eine Anzeigevorrichtung und das zumindest eine Gegengewichtselement bewegungsgekoppelt sein, so dass eine Bewegung der zumindest einen Anzeigevorrichtung eine entgegengesetzte Bewegung des zumindest einen Gegengewichtelements bedingt. Die entgegengesetzte Richtung betrifft eine Bewegung des Gegengewichtselements in eine Richtung, die die Veränderung des Schwerpunkts durch die Bewegung der Anzeigevorrichtung zumindest teilweise ausgleicht. Die Bewegung kann dabei translatorische und/oder rotatorische Bewegungsanteile aufweisen.

In einer Ausgestaltung beträgt das Gewicht des Gegengewichtselements oder das Gesamtgewicht mehrerer Gegengewichtselemente mindestens 10 %, insbesondere mindestens 30 %, bevorzugt mindestens 50 %, und höchstens 150%, insbesondere höchsten 120 %, bevorzugt höchstens 90 % der zumindest einen Anzeigevorrichtung.

Insbesondere ist das Gewicht des Gegengewichtselements oder das Gesamtgewicht der Gegengewichtselemente derart bemessen, dass es das Anzeigevorrichtungsmoment zumindest in einer Position des zumindest einen Gewichtselements und der zumindest einen Anzeigevorrichtung an bzw. relativ zur Trägervorrichtung verringert, bevorzugt auf zumindest die Hälfte reduziert, besonders bevorzugt vollständig ausgleicht.

Das Gewicht des Gegengewichtselements bzw. das Gesamtgewicht mehrerer Gegengewichtselemente kann auch in Abhängigkeit der jeweiligen Position des entsprechenden Gegengewichtselements gewählt werden. Beispielweise kann das Gewicht eines jeweiligen Gegengewichtselements geringer gewählt werden, wenn die Entfernung zu der zumindest einen Anzeigevorrichtung größer wird, im Vergleich zu einem höheren Gewicht des Gegengewichtselements, wenn dies näher an der zumindest einen Anzeigevorrichtung angeordnet ist. Die entsprechend vorteilhaften Gewichtsverteilungen ergeben sich aus dem Momentengleichgewicht.

In einer Ausgestaltung weist die HDM-Vorrichtung eine Steuerungseinheit zur Ansteuerung der zumindest einen Anzeigevorrichtung auf, die an der Trägervorrichtung angeordnet ist. Die Steuerungseinheit ist dabei an verschiedenen Positionen der Trägervorrichtung und/oder in verschiedenen Position relativ zur Trägervorrichtung anordenbar.

Durch die Anordnung der Steuerungseinheit an der Trägervorrichtung, wirkt sich das Gewicht der Steuerungseinheit nicht auf das Gewicht der zumindest einen Anzeigevorrichtung und somit das Anzeigevorrichtungsmoment aus. Zudem kann die Steuerungseinheit durch die Anordnung an bzw. in unterschiedlichen Positionen ebenfalls dazu genutzt werden, das Anzeigevorrichtungsmoment zumindest teilweise auszugleichen. Die Steuerungseinheit kann dazu beispielweise ebenfalls in einem Bereich der Trägervorrichtung angeordnet werden, so dass das durch die Gewichtskraft der Steuerungseinheit bedingte Steuerungseinheitsmoment dem durch die Gewichtskraft der Anzeigevorrichtung bedingten Anzeigevorrichtungsmoment entgegen wirkt. In einer Ausgestaltung kann die Steuerungseinheit dadurch das Gegengewichtselement darstellen. Alternativ kann die Steuerungseinheit aber auch zusätzlich zu dem zumindest einen Gegengewichtselement an der Trägervorrichtung angeordnet sein.

Die Anordenbarkeit der Steuerungseinheit an verschiedenen Positionen der Trägervorrichtung und/oder in verschiedenen Position relativ zur Trägervorrichtung kann vergleichbar zur entsprechenden Anordenbarkeit des zumindest einen Gegengewichtselements zur Anpassung an verschiedene Anzeigevorrichtungen und/oder eine Veränderung der Relativposition der zumindest einen Anzeigevorrichtung zur Trägervorrichtung genutzt werden.

In einer Ausgestaltung ist die Steuerungseinheit entlang der Trägervorrichtung bewegbar.

Hierdurch kann die Steuerungseinheit in einfacher Weise an verschiedenen Positionen entlang der Trägervorrichtung angeordnet werden. Zum Beispiel kann die Trägervorrichtung eine Führung für die Steuerungseinheit ausbilden. Bevorzugt kann ein Befestigungsabschnitt der Trägervorrichtung als eine solche Führung ausgestaltet sein, so dass keine zusätzlichen Trägerabschnitte für eine Positionsänderung der Steuerungseinheit vorgesehen werden müssen.

Die Bewegung der Steuerungseinheit entlang der Trägervorrichtung kann manuell und/oder durch einen entsprechenden Antrieb erfolgen. Bei einer signaltechnischen Bewegung über einen Antrieb, wie beispielsweise infolge der Betätigung eines Fußschalters, anderweitiger Schaltelemente und/oder der Ausführung und Erkennung von Gesten, kann die Flexibilität des Nutzers der HMD-Vorrichtung erhöht werden.

In einer Ausgestaltung ist die Steuerungseinheit oder eine andere Steuerungseinheit dazu konfiguriert, die Position der Steuerungseinheit an und/oder relativ zur Trägervorrichtung in Abhängigkeit einer Bewegung und/oder eines Gewichts der zumindest einen Anzeigevorrichtung zu verändern.

Vergleichbar zur Veränderung der Position des Gegengewichtselements in Reaktion auf eine Veränderung der Position der zumindest einen Anzeigevorrichtung relativ zur Trägervorrichtung kann somit alternativ oder ergänzend auch die Position der Steuerungseinheit in Abhängigkeit einer Bewegung und/oder eines veränderten Gewichts der zumindest einen Anzeigevorrichtung angepasst werden. Entsprechende diesbezügliche Ausführungen zum Gegengewichtselement sind gleichermaßen auf die Steuerungseinheit übertragbar und umgekehrt.

Demnach kann beispielsweise die Steuerungseinheit mit der zumindest einen Anzeigevorrichtung mechanisch bewegungsgekoppelt sein. Alternativ oder ergänzend kann die Steuerungseinheit oder eine andere Steuerungseinheit einen entsprechenden Antrieb zur Bewegung der Steuerungseinheit in eine andere Relativposition zur Trägervorrichtung signaltechnisch ansteuern. Sofern die Steuerungseinheit zum Beispiel an Ansteuerungssignal zur Veränderung einer Relativposition der zumindest einen Anzeigevorrichtung vorgibt, kann dieses Ansteuerungssignal bzw. das entsprechende Auslösesignal für das Ansteuerungssignal gleichermaßen zur Ansteuerung einer Ausgleichsbewegung der Steuerungseinheit genutzt werden.

In einer Ausgestaltung erstreckt sich der zumindest eine Befestigungsabschnitt der Trägervorrichtung im anwendungsgerechten Gebrauch zumindest teilweise entlang des Hinterhauptbeins eines Nutzers.

Die Trägervorrichtung kann somit über den Befestigungsabschnitt entlang des Hinterhauptbeins eines Nutzers über das Hinterhauptbein zusätzlich gehalten werden. Die Trägervorrichtung kann in einer Ausgestaltung zumindest einen ringförmigen Trägerkörper, wie einen Trägerriemen oder ein Trägergestell, aufweisen, der sich um einen Kopfumfang radial zu einer Verlängerung der Wirbelsäule bei aufrechter Kopfhaltung erstreckt. Der ringförmige Trägerkörper verläuft dabei im anwendungsgerechten Gebrauch, also bei ordnungsgemäßem Tragen der HMD-Vorrichtung, in einem Abschnitt in Kopfumfangsrichtung entlang des Hinterhauptbeins, also einem Abschnitt des Kopfes, der gegenüber dem maximalen Kopfumfang rückversetzt ist.

In einer Ausgestaltung wird der Befestigungsabschnitt zumindest aus einem sich zumindest teilweise entlang des Stirnbeins eines Nutzers erstreckenden Vorderkopfabschnitt und einem sich zumindest teilweise entlang des Hinterhauptbeins eines Nutzers erstreckenden Hinterkopfabschnitt gebildet. Dabei bilden der Vorderkopfabschnitt und der Hinterkopfabschnitt in einem anwendungsgerechten Gebrauch der HMD-Vorrichtung in einer vertikalen Ebene einen Anstellwinkel aus.

Wieder bezugnehmend auf den exemplarischen ringförmigen Trägerkörper, der die Trägervorrichtung ausbildet oder zumindest ein Teil der Trägervorrichtung ist, erstreckt sich der ringförmige Trägerkörper somit nicht in einer geraden Linie um den Kopfumfang, sondern weist zumindest zwei zueinander um den Anstellwinkel geneigte Abschnitte auf. Der Hinterkopfabschnitt ist dabei im anwendungsgerechten Gebrauch gegenüber dem Vorderkopfabschnitt nach unten, also in Richtung eines Rumpfs eines Nutzers, geneigt. Hierdurch kann der Hinterkopfabschnitt in komfortabler Weise um das Hinterhauptbein geführt werden, wobei der Vorderkopfabschnitt immer noch ausreichend tief in der Stirn eines Nutzers anordenbar ist. Zudem kann durch den Anstellwinkel auch vermieden werden, dass der ringförmige Trägerkörper über die Ohren eines Nutzers geführt werden muss. Diesbezüglich erstreckt sich die Abwinklung des Hinterkopfabschnitts im anwendungsgerechten Gebrauch bevorzugt von der Stirn aus gesehen erst hinter einem Ohr eines Nutzers mit dem entsprechenden Anstellwinkel um das Hinterhauptbein. Hierzu sei ergänzend angemerkt, dass sich die Ausgestaltung dabei nach Durchschnittsanatomiewerten üblicher Nutzergruppen richten kann und/oder entsprechende Verstellmöglichkeiten vorgesehen sein können.

In eine Ausgestaltung bildet der Anstellwinkel einen Winkel zwischen 5° und 30°, insbesondere zwischen 10° und 20°, aus und/oder der Anstellwinkel (β) ist über einen Verstellmechanismus (23) anpassbar ist.

Durch den Verstellmechanismus kann alternativ oder ergänzend zur Veränderung eines Beginns des Anstellwinkels entlang des Befestigungsabschnitts auch der Anstellwinkel selbst anpassbar sein. Dies kann dazu genutzt werden, den Anstellwinkel an individuelle Anatomieverhältnisse anzupassen und/oder die Tragposition bei längeren Eingriffen oder aus anderen Gründen verändern zu können. Über die Anpassung des Anstellwinkels kann auch ein am Hinterkopfabschnitt befestigtes Gegengewichtselement in seiner Position verändert werden, wenn dieses bei einer Bewegung des Hinterkopfabschnitts mitbewegt wird. Der Hinterkopfabschnitt kann am Vorderkopfabschnitt drehbar gelagert sein. Hierdurch kann beispielweise eine bessere Anpassung an individuelle Kopfformen und/oder Tragevorliegen eines Nutzers erfolgen. Der Anstellwinkel kann dazu beitragen, den Hinterkopfabschnitt am Hinterhauptbein zu platzieren. Dabei kann auch ein Nachvornerutschen der Trägervorrichtung verhindert werden.

Der Verstellmechanismus kann als Stellschraube, Schieber oder dergleichen ausgebildet sein, dessen Bewegung selbst eine Verstellung des Anstellwinkels bewirkt. Alternativ können der Hinterkopfabschnitt und der Vorderkopfabschnitt auch über ein Gelenk miteinander verbunden sein, wobei durch den Verstellmechanismus das Gelenk verriegel- und entriegelbar ist.

In einer Ausgestaltung ist das zumindest eine Gegengewichtselement ein Funktionselement der HMD-Vorrichtung.

Beispielsweise kann das Gegengewichtselement ein Einstellmechanismus, wie beispielsweise eine Stellschraube für eine Weiteneinstellung des ringförmigen Trägerkörpers, sein. Demnach sind keine zusätzlichen Komponenten als Gegengewichtselement zwingend erforderlich.

In einer Ausgestaltung ist die HMD-Vorrichtung Teil eines roboterunterstützten Visualisierungssystems, insbesondere für minimalinvasive Eingriffe ist.

Durch die ergonomische Ausgestaltung der HMD-Vorrichtung kann der Nutzer gerade bei komplexen Anwendungen im Bereich robotergestützter Visualisierungssysteme entlastet werden, ohne zur Erhöhung des Tragekomforts Funktionalitäten der HMD-Vorrichtung einbüßen zu müssen. Insbesondere in Verbindung mit einer über Kopfbewegungen gesteuerten HMD-Vorrichtung ist der Ausgleich des Anzeigevorrichtungsmoments vorteilhaft, da das Anzeigevorrichtungsmoment, das dazu tendieren kann, den Kopf eines Nutzers nach unten zu ziehen, eine Steuerung über genaue Kopfbewegungen andernfalls erschwert.

Ein weiterer Aspekt der vorliegenden Erfindung betrifft ein Gegengewichtselement zur Anordnung an einer Trägervorrichtung einer zuvor beschriebenen HMD-Vorrichtung, wobei das Gewicht des Gegengewichtselements veränderbar ist.

Durch Veränderung des Gewichts des Gegengewichtselements kann das hierüber wirkende Gegengewichtsmoment angepasst werden. Dies kann alternativ oder ergänzend zu einer Veränderung der Relativposition des Gegengewichtselements an bzw. zur Trägervorrichtung erfolgen.

In einer Ausgestaltung ist das Gegengewichtselement als befüllbarer Hohlkörper ausgebildet.

Der befüllbare Hohlkörper kann beispielsweise vor einem Eingriff mit einem Fluid und/oder Festkörpern, beispielsweise Kügelchen, befüllt werden. Alternativ oder ergänzend kann das Gegengewichtselement aber auch bei Verbindung mit einem entsprechenden Zuleitungskanal während eines Eingriffs variabel mit Füllstoffen befüllt werden. Die Gewichtsänderung kann dabei durch eine Absaugung über die gleiche oder eine weitere Leitung auch reduziert bzw. wieder reduziert werden. Eine gesteuerte Befüllung und/oder Absaugung kann über die Steuerungseinheit oder eine weitere anderweitige Steuerungseinheit vorgesehen werden. Die Ansteuerung kann insbesondere auf einem Ansteuerungssignals einer Bewegung der zumindest einen Anzeigevorrichtung und/oder auf einem Gewichtssensorsignal, das zu einem Gewicht der zumindest einen Anzeigevorrichtung korrespondiert, basieren.

Alternativ oder ergänzend zu einem befüllbaren Hohlkörper kann eine Gewichtsänderung des Gegengewichtselements auch durch das Anbringen und Entfernen von Gegengewichtselementkomponenten und/oder Zusatzgegengewichtselementen am bzw. vom Gegengewichtelement erfolgen.

Ein weiterer Aspekt der vorliegenden Erfindung betrifft ein Gegengewichtselement zur Anordnung an einer Trägervorrichtung einer zuvor beschriebenen HMD-Vorrichtung oder eine weitere Ausgestaltung des zuvor beschriebenen Gegengewichtselements, wobei das Gegengewichtselement zumindest einen magnetischen Abschnitt, insbesondere einen elektromagnetischen Abschnitt, zur Befestigung des Gegengewichtselements an der Trägervorrichtung aufweist.

Über den magnetischen Abschnitt kann das Gegengewichtselement in einfacher und flexibler Weise an gegenpoligen magnetischen Abschnitten der Trägervorrichtung befestigt und wieder entfernt werden. Durch elektromagnetische Abschnitte an dem Gegengewichtselement und/oder der Trägervorrichtung kann die Befestigungsmöglichkeit gezielt aktiviert und deaktiviert werden.

Die bei der vorstehenden Beschreibung der HMD-Vorrichtung beschriebenen Merkmale sind gleichermaßen auf das Gegengewichtselement anwendbar, sofern sie dieses betreffen. Ebenso sind zum Gegengewichtselement beschriebene Merkmale auf die HMD-Vorrichtung übertragbar, sofern sie nicht bereits hierzu schon beschrieben wurden.

Im Einzelnen zeigt
Fig. 1 eine schematische Seitenansicht einer HMD-Vorrichtung gemäß einer exemplarischen Ausführungsform bei heruntergeklappter Anzeigevorrichtung;
Fig. 2 eine schematische Seitenansicht einer HMD-Vorrichtung gemäß einer exemplarischen Ausführungsform gemäß Fig. 1 bei heraufgeklappter Anzeigevorrichtung;
Fig. 3 eine schematische Seitenansicht einer HMD-Vorrichtung gemäß einer exemplarischen Ausführungsform gemäß Fig. 1 zur Verdeutlichung eines Anstellwinkels; und
Fig. 4 eine schematische Seitenansicht einer HMD-Vorrichtung gemäß einer exemplarischen Ausführungsform gemäß Fig. 2 zur Verdeutlichung von Verstellmöglichkeiten.

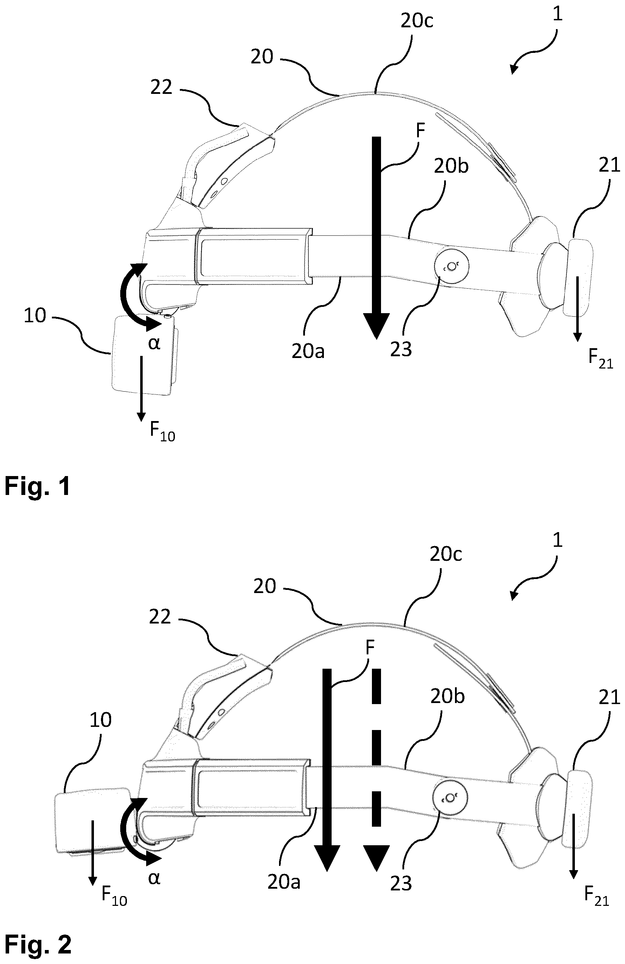

Fig. 1 zeigt eine schematische Seitenansicht einer HMD-Vorrichtung 1 gemäß einer exemplarischen Ausführungsform bei heruntergeklappter Anzeigevorrichtung 10. Die Anzeigevorrichtung 10 ist eine Einheit mit zwei Okularen, wobei aufgrund der Seitenansicht nur ein Okular sichtbar ist. In einer alternativen Ausführungsform kann die HMD-Vorrichtung 1 auch zwei Anzeigevorrichtungen aufweisen, die jeweils ein Okular umfassen. Die zwei Anzeigevorrichtungen können dabei jeweils unterschiedlich ansteuerbar sein, so dass für ein jeweiliges Auge eines Nutzers eine unabhängige Anzeigeposition ermöglicht wird.

Die Anzeigevorrichtung 10 ist in der vorliegenden Ausführungsform über ein Drehgelenk, repräsentiert durch den Schwenkwinkel α, an einer Trägervorrichtung 20 befestigt. Der Schwenkwinkel α betrifft ein Verschenken der Anzeigevorrichtung 10 um eine Achse parallel zu einer Verbindunglinie der Augen eines Nutzers. Entsprechend kann die Anzeigevorrichtung in das Sichtfeld eines Nutzers hinein und hinaus geschwenkt werden, wobei auch Zwischenpositionen möglich sind.

Die Trägervorrichtung 20 weist einen ringförmigen Trägerkörper 20a, 20b, der einen Kopfumfang eines Nutzers in Bezug auf eine Verlängerung der Wirbelsäule bei aufrechter Kopfhaltung radial umgibt, sowie einen Elevationsträgerabschnitt 20c auf. Der Elevationsabschnitt 20c erstreckt sich bogenförmig von der durch den ringförmigen Trägerkörper 20a, 20b gebildeten Ebene, um zwei gegenüberliegende Punkte des ringförmigen Trägerkörpers 20a, 20b zu verbinden. In der beispielhaften Ausführungsform erstreckt sich der Elevationsabschnitt 20c als Streifen von einer in anwendungsgerechten Gebrauch anzunehmenden Stirn- bzw. Stirnbeinmitte über das Scheitelbein hin zum Hinterhauptbein eines Nutzers. Der ringförmiger Trägerkörper 20a, 20b wird aus einem Vorderkopfabschnitt 20a, der in Kopfumfangsrichtung über das Stirnbein verläuft, und einem Hinterkopfabschnitt 20b, der sich in Kopfumfangsrichtung um das Hinterhauptbein erstreckt, ausgebildet. Der Vorderkopfabschnitt 20a, der Hinterkopfabschnitt 20b und der Elevationsabschnitt 20c bilden jeweils Befestigungsabschnitte der Trägervorrichtung 20 aus, um die Trägervorrichtung auf einem Kopf eines Nutzers halten zu können.

An dem Elevationsabschnitt 20c ist eine Steuerungseinheit 22 befestigt, um die Anzeigevorrichtung 10 anzusteuern. Die Ansteuerung umfasst die Steuerung der Bewegung der Anzeigevorrichtung 10 gemäß dem Schwenkwinkel α, um beispielweise die Anzeigevorrichtung 10 in das Sichtfeld eines Nutzers einzuschwenken und wieder heraus zu schwenken, d.h. die Anzeigevorrichtung 10 herunter- und heraufzuklappen. Zudem können Bilddarstellungen auf einem Anzeigebereich der Anzeigevorrichtung 10 durch die Steuerungseinheit 22, wie eine Vergrößerung, eine Bildausschnittsänderung, eine Helligkeit oder dergleichen, gesteuert werden. Die Steuerungseinheit 22 ist hier in Bezug auf einen anwendungsgemäßen Gebrauch in einem Stirnbeinbereich eines Nutzers angeordnet.

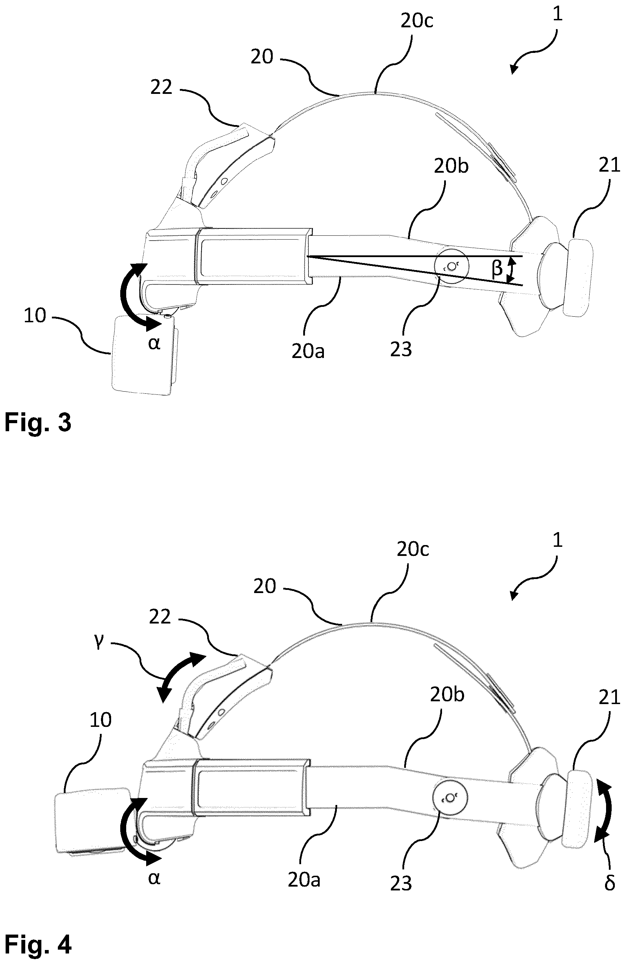

Der Hinterkopfabschnitt 20b weist in einer Mitte des Hinterhauptbeins eines Nutzers in Bezug auf die Kopfumfangsrichtung ein Gegengewichtselement 21 auf. Das Gegengewichtselement 21 liegt dabei der Anzeigevorrichtung 10 in Bezug auf eine Verlängerung der Wirbelsäule bei aufrechter Kopfhaltung gegenüber. Das Gegengewichtselement 21 ist hier gleichzeitig als Weiteneinstellmechanismus des ringförmigen Trägerkörpers 20a, 20b ausgebildet. Der Weiteneinstellmechanismus bzw. das Gegengewichtelement 21 ist in der gezeigten Ausführungsform beispielhaft als Einstellrad ausgebildet. Zudem weist der Hinterkopfabschnitt 20b einen Verstellmechanismus 23 zur Einstellung eines Anstellwinkels β auf, wie dies noch in Bezug auf Fig. 3 beschrieben wird.

Durch das Gewicht der Anzeigevorrichtung 10 wirkt eine Gewichtskraft F₁₀ der Anzeigevorrichtung 10 auf die Trägervorrichtung 20. Hierdurch wird ein Anzeigevorrichtungsmoment auf die Trägervorrichtung aufgebracht, das in der gezeigten Darstellung entgegen des Uhrzeigersinns wirkt. Da das gegenüberliegende Gegengewichtselement 21 durch sein Gewicht gleichermaßen eine Gewichtskraft F₂₁ des Gegengewichtselements 21 aufbringt, die in einem Gegengewichtsmoment resultiert, kann die Wirkung des Anzeigevorrichtungsmoments zumindest teilweise kompensiert werden. Das Gegengewichtsmoment wirkt dabei entgegengesetzt zum Anzeigevorrichtungsmoment, in der gezeigten Darstellung also im Uhrzeigersinn. Das Gewicht des Gegengewichtselements 21 wird dabei so gewählt, dass die resultierende Kraft im Schwerpunkt F gemäß dem repräsentierenden Pfeil im Wesentlichen in einem Bereich der Verlängerung der Wirbelsäule bei aufrechter Kopfhaltung eines Nutzers wirkt. Der Bereich der Verlängerung der Wirbelsäule wird im Folgenden auch als Referenzschwerpunkt bezeichnet. Unter der Annahme, dass die Entfernung der Anzeigevorrichtung 10 und des Gegengewichtselements 21 vom Referenzschwerpunkt in etwas gleich ist, entspricht auch das Gewicht des Gegengewichtselements 21 in etwa dem Gewicht der Anzeigevorrichtung 10. Bei aufrechter Kopfhaltung gleichen sich das Anzeigevorrichtungsmoment und das Gegengewichtsmoment somit aus. Der Referenzschwerpunkt kann aber auch je nach überwiegender Kopfhaltung eines Nutzers anders vorbestimmt und/oder während eines Tragens der HMD-Vorrichtung 1 in Abhängigkeit einer Kopfhaltung oder aber für einen Wechsel des Hauptbelastungspunkts verändert werden. Sofern aber auch andere Komponenten der HMD-Vorrichtung 1, wie beispielsweise die Steuerungseinheit 22, durch eine jeweilige Gewichtskraft bei einem Momentenausgleich berücksichtigt werden müssen, so kann je nach Lage dieser Komponenten das Gegengewichtselement 21 auch ein höheres oder niedrigeres Gewicht aufweisen. Folglich ist dann das Gegengewichtselement 21 nicht nur auf die Anzeigevorrichtung 10 abgestimmt, sondern auf das insgesamt jenseits des Referenzschwerpunkts gegenüberliegend des Gegengewichtselements 21 wirkende Moment.

Fig. 2 zeigt eine schematische Seitenansicht der HMD-Vorrichtung 1 gemäß Fig. 1 bei heraufgeklappter Anzeigevorrichtung 10. Durch das Verschwenken der Anzeigevorrichtung 10 aus der heruntergeklappten Position um einen Schwenkwinkel α von hier etwa 80° bis 90° vom Kopfumfang weg, in der gezeigten Darstellung also im Uhrzeigersinn, verlagert sich der Angriffspunkt der Gewichtskraft F₁₀ der Anzeigevorrichtung 10 in eine größere Entfernung zum Referenzschwerpunkt. Die resultierende Kraft im Schwerpunkt F wirkt somit nun in einem gleichermaßen in Richtung Stirnbein verlagerten Punkt. Diese Verlagerung wird durch den gestrichelten Pfeil als vorheriger Kraftangriffspunkt und durch den durchgängigen Pfeil als verlagerter Kraftangriffspunkt verdeutlicht. Die Gewichtskraft F₂₁ des Gegengewichtselements 21 ist dennoch ausreichend bemessen, um den verlagerten Kraftangriffspunkt in einem Toleranzbereich zu halten. Der Toleranzbereich deckt hier zum Beispiel einen Bereich ab, der sich radial um den Referenzschwerpunkt in Bezug auf eine Verlängerung der Wirbelsäule bei aufrechter Kopfhaltung erstreckt und hierbei nicht über den Hals eines Nutzers hinausgeht.

Fig. 3 zeigt eine schematische Seitenansicht der HMD-Vorrichtung 1 gemäß Fig. 1 zur Verdeutlichung des Anstellwinkels β. Der Anstellwinkel β repräsentiert die Neigung des Hinterkopfabschnitts 20b gegenüber dem Vorderkopfabschnitt 20a. Ausgehend von der geradlinigen Erstreckung des Vorderkopfabschnitts 20a erstreckt sich der Hinterkopfabschnitt 20b mit dem Anstellwinkel β in eine dem Elevationsabschnitt 20c abgewandte Richtung. Entsprechend wird der Hinterkopfabschnitt 20b im Vergleich zu einem vom Vorderkopfabschnitt 20a weiter geradlinigen Verlauf in einem vom Scheitelbein abgewandten tieferen Verlauf am Hinterhauptbein entlang geführt. Dadurch kann die Trägervorrichtung 20 über das Hinterhauptbein besser gehalten werden. Über den Anstellwinkel β kann dabei der ringförmige Trägerkörper 20a. 20b auch besser an den Ohren eines Nutzers vorbeigeführt werden.

Zur Einstellung des Anstellwinkel β weist der Hinterkopfabschnitt 20b einen Verstellmechanismus 23 auf. Der Verstellmechanismus 23 ist auf beiden Seiten der Trägervorrichtung 20 vorgesehen, wobei aufgrund der Darstellung der Verstellmechanismus 23 auf der anderen Seite der Trägervorrichtung 20 verdeckt ist.

Fig. 4 zeigt eine schematische Seitenansicht der HMD-Vorrichtung 1 gemäß Fig. 2 zur Verdeutlichung von Verstellmöglichkeiten. Wie zu Fig. 2 beschreiben kommt es durch das Heraufklappen der Anzeigevorrichtung 10 zu einer Verlagerung des Kraftangriffspunkt der resultierenden Kraft im Schwerpunkt F. Sofern dieser Verlagerung des Kraftangriffspunkt entgegengewirkt werden soll oder auch aus anderen Gründen eine Veränderung des Referenzschwerpunkts vorgesehen ist, bietet die HMD-Vorrichtung hierfür verschiedene Verstellmöglichkeiten an.

Wie durch den Doppelpfeil als Steuerungseinheitsbewegung γ angegeben, ist die Steuerungseinheit 22 bidirektional entlang des Elevationsabschnitts 20 beweglich. Wird beispielsweise die Anzeigevorrichtung 10 manuell heraufgeklappt, kann die Steuerungseinheit gleichermaßen entlang des Elevationsabschnitts 20c geführt manuell in Richtung Scheitelbein, also von der Anzeigevorrichtung 10 weg, bewegt werden. Bei einem Herunterklappen der Anzeigevorrichtung 10 kann die Steuerungseinheit wieder in die entgegengesetzte Richtung bewegt werden. Die Bewegung der Steuerungseinheit 22 kann auch für eine individuelle Einstellung der Momentenverhältnisse nach Nutzerpräferenzen verwendet werden. Die Steuerungseinheit 22 ist zudem dazu ausgebildet, die Anzeigevorrichtung 10 bei entsprechender Ansteuerung um einen entsprechenden Schwenkwinkel α zu verschwenken. Dabei kann Steuerungseinheit 22 gleichermaßen einen Antrieb zur Bewegung der Steuerungseinheit 22 ansteuern, so dass die vorstehend beschriebene manuelle Veränderung der Relativposition der Steuerungseinheit 22 entlang des Elevationsabschnitts 20c automatisch erfolgt. Die Steuerungseinheit 22 kann dabei ein Zeitglied und/oder einen Mindestwert des Schwenkwinkels α berücksichtigen, so dass nur kurzfristige und/oder geringe Positionsänderungen der Anzeigevorrichtung 10 nicht zu einem zu häufigen bzw. nicht zweckmäßigem Bewegung der Steuerungseinheit 22 führen. Auch wenn hier die Steuerungseinheit 22 sowohl manuell als auch gesteuert bewegbar ist, kann in alternativen Ausführungsformen auch nur eine der Bewegungsvarianten gegeben sein, sofern eine Bewegung der Steuerungseinheit 22 vorgesehen ist.

Zudem ist das Gegengewichtselement 21 wie durch den Doppelpfeil als Gegengewichtsbewegung δ angegeben entlang des Hinterhauptbeins in eine dem Scheitelbein zugewandte und abgewandte Richtung ebenfalls bewegbar. Dies kann über eine gelenkige Anordnung des Gegengewichtelements 21 an dem Hinterkopfabschnitt 20b erfolgen. Grundsätzlich kann eine solche Bewegung aber auch über den Verstellmechanismus 23 zur Änderung des Anstellwinkels β vorgenommen werden. Wird die Anzeigevorrichtung 10 beispielsweise, wie in Fig. 4 gezeigt, in eine heraufgeklappte Position bewegt, kann das Gegengewichtselement 21 in Richtung des Scheitelbeins bewegt werden, um den Abstand zum Referenzschwerpunkt zu vergrößern, und umgekehrt. Die Bewegung des Gegengewichtelements 21 kann alternativ oder ergänzend zur Bewegung der Steuerungseinheit 22 erfolgen.

Die Erfindung ist nicht auf die beschriebene Ausführungsform beschränkt. Insbesondere sind zu der Ausführungsform, anderweitig beschriebenen Ausgestaltungen und Weiterbildungen der Erfindung beschriebene Merkmale untereinander kombinierbar, sofern sie sich nicht vernünftigerweise ausschließen. Auch können einzelne Merkmale für sich genommen als eigenständig erachtet werden, auch wenn sie in einer Ausführungsform mit anderen Merkmalen zusammen angegeben werden. Auch wenn nur ein Gegengewichtselement in der beschriebenen Ausführungsform gezeigt ist, können auch mehrere Gegengewichtselemente verwendet werden. Zudem ist die Position des zumindest einen Gegengewichtselements relativ zur Trägervorrichtung nicht auf eine der Anzeigevorrichtung gegenüberliegende Position beschränkt. Entsprechend kann auch vorgesehen sein, das zumindest einen Gegengewichtselement 21 entlang des Hinterkopfabschnitts 20b in Kopfumfangsrichtung bidirektional bewegen zu können.

### Liste der Bezugszeichen

- 1: HMD-Vorrichtung
- 10: Anzeigevorrichtung
- 20: Trägervorrichtung
- 20a: Vorderkopfabschnitt
- 20b: Hinterkopfabschnitt
- 20c: Elevationsträgerabschnitt
- 21: Gegengewichtselement
- 22: Steuerungseinheit
- 23: Verstellmechanismus
- F: Kraft im Schwerpunkt
- F₁₀: Gewichtskraft der Anzeigevorrichtung
- F₂₁: Gewichtskraft des Gegengewichtselements
- α: Schwenkwinkel (Anzeigevorrichtung)
- β: Anstellwinkel
- γ: Steuerungseinheitsbewegung
- δ: Gegengewichtsbewegung

## Patentansprüche

1. HMD-Vorrichtung (1), aufweisend:
zumindest eine Anzeigevorrichtung (10) zur Anzeige eines aufgenommenen Bildes,
eine Trägervorrichtung (20), an der die zumindest eine Anzeigevorrichtung (10) befestigt ist und zumindest einen Befestigungsabschnitt zur Befestigung an einem Kopf eines Nutzers aufweist, und
zumindest ein Gegengewichtselement (21), über das eine Gegengewichtskraft zur Gewichtskraft der zumindest einen Anzeigevorrichtung aufbringbar ist, wobei
das zumindest eine Gegengewichtselement (21) derart an der Trägervorrichtung (20) angeordnet ist, dass das durch die Gewichtskraft des Gegengewichtselement (21) bedingte Gegengewichtsmoment dem durch die Gewichtskraft der Anzeigevorrichtung (10) bedingten Anzeigevorrichtungsmoment entgegengesetzt wirkt.

2. HMD-Vorrichtung (1) nach Anspruch 1, wobei
das Gegengewichtselement (21) lösbar mit der Trägervorrichtung (20) verbindbar ist.

3. HMD-Vorrichtung (1) nach Anspruch 1 oder 2, wobei
das Gegengewichtselement (21) an verschiedenen Positionen der Trägervorrichtung (20) und/oder in verschiedenen Position relativ zur Trägervorrichtung (20) anordenbar ist.

4. HMD-Vorrichtung (1) nach Anspruch 3, wobei
die HMD-Vorrichtung (1) dazu konfiguriert ist, die Position des zumindest einen Gegengewichtselements (21) an und/oder zur Trägervorrichtung (20) in Abhängigkeit einer Bewegung und/oder eines Gewichts der zumindest einen Anzeigevorrichtung (10) zu verändern.

5. HDM-Vorrichtung (1) nach einem der vorhergehenden Ansprüche, wobei
das Gewicht des Gegengewichtselements (21) oder das Gesamtgewicht mehrerer Gegengewichtselemente (21) mindestens 10 %, insbesondere mindestens 30 %, bevorzugt mindestens 50 %, und höchstens 150%, insbesondere höchsten 120 %, bevorzugt höchstens 90 % der zumindest einen Anzeigevorrichtung (10) beträgt.

6. HMD-Vorrichtung (1) nach einem der vorhergehenden Ansprüche, wobei
die HDM-Vorrichtung (1) eine Steuerungseinheit (22) zur Ansteuerung der zumindest einen Anzeigevorrichtung aufweist, die an der Trägervorrichtung (20) angeordnet ist, und wobei
die Steuerungseinheit (22) an verschiedenen Positionen der Trägervorrichtung (20) und/oder in verschiedenen Position relativ zur Trägervorrichtung (20) anordenbar ist.

7. HMD-Vorrichtung nach Anspruch 6, wobei
die Steuerungseinheit (22) entlang der Trägervorrichtung (20) bewegbar ist.

8. HMD-Vorrichtung (1) nach Anspruch 6 oder 7, wobei
die Steuerungseinheit (22) oder eine andere Steuerungseinheit dazu konfiguriert ist, die Position der Steuerungseinheit (22) an und/oder relativ zur Trägervorrichtung (20) in Abhängigkeit einer Bewegung und/oder eines Gewichts der zumindest einen Anzeigevorrichtung (10) zu verändern.

9. HMD-Vorrichtung (1) nach einem der vorhergehenden Ansprüche, wobei
sich der zumindest eine Befestigungsabschnitt der Trägervorrichtung (20) im anwendungsgerechten Gebrauch zumindest teilweise entlang des Hinterhauptbeins eines Nutzers erstreckt.

10. HMD-Vorrichtung (1) nach Anspruch 9, wobei
der Befestigungsabschnitt zumindest aus einem sich zumindest teilweise entlang des Stirnbeins eines Nutzers erstreckenden Vorderkopfabschnitt (20a) und einem sich zumindest teilweise entlang des Hinterhauptbeins eines Nutzers erstreckenden Hinterkopfabschnitt (20b) gebildet wird, und wobei
der Vorderkopfabschnitt (20a) und der Hinterkopfabschnitt (20b) in einem anwendungsgerechten Gebrauch der HMD-Vorrichtung in einer vertikalen Ebene einen Anstellwinkel (β) ausbilden.

11. HMD-Vorrichtung nach Anspruch 10, wobei
der Anstellwinkel (β) einen Winkel zwischen 5° und 30°, insbesondere zwischen 10° und 20°, ausbildet, und/oder
der Anstellwinkel (β) über einen Verstellmechanismus (23) anpassbar ist.

12. HMD-Vorrichtung (1) nach einem der vorhergehenden Ansprüche, wobei
das zumindest eine Gegengewichtselement (21) ein Funktionselement der HMD-Vorrichtung (1) ist.

13. HMD-Vorrichtung (1) nach einem der vorhergehenden Ansprüche, wobei
die HMD-Vorrichtung (1) Teil eines roboterunterstützten Visualisierungssystems, insbesondere für minimalinvasive Eingriffe ist.

14. Gegengewichtselement (21) zur Anordnung an einer Trägervorrichtung (20) einer HMD-Vorrichtung (1) nach einem der Ansprüche 1 bis 13, wobei
das Gewicht des Gegengewichtselements (21) veränderbar ist.

15. Gegengewichtselement (21) nach Anspruch 14, wobei
das Gegengewichtselement (21) als befüllbarer Hohlkörper ausgebildet ist.

16. Gegengewichtselement (21) nach Anspruch 14 oder 15 oder zur Anordnung an einer Trägervorrichtung (20) einer HMD-Vorrichtung (1) nach einem der Ansprüche 1 bis 13, wobei
das Gegengewichtselement (21) zumindest einen magnetischen Abschnitt, insbesondere einen elektromagnetischen Abschnitt, zur Befestigung des Gegengewichtselements (21) an der Trägervorrichtung aufweist.
